(19) Europäisches Patentamt
European Patent Office
Office européen des brevets

(11) Publication number: **0 060 078**
**B1**

# (12) EUROPEAN PATENT SPECIFICATION

(45) Date of publication of patent specification: **01.06.88**

(51) Int. Cl.$^4$: **G 11 C 17/00**

(21) Application number: **82301063.2**

(22) Date of filing: **02.03.82**

## (54) Read-only memory device.

(30) Priority: **06.03.81 JP 32125/81**

(43) Date of publication of application:
**15.09.82 Bulletin 82/37**

(45) Publication of the grant of the patent:
**01.06.88 Bulletin 88/22**

(84) Designated Contracting States:
**DE FR GB NL**

(56) References cited:
**EP-A-0 020 054**
**WO-A-81/00154**
**US-A-4 103 349**

(73) Proprietor: **FUJITSU LIMITED**
**1015, Kamikodanaka Nakahara-ku**
**Kawasaki-shi Kanagawa 211 (JP)**

(72) Inventor: **Suzuki, Yasuo c/o Azuma**
**11-16, Shiratoridai Midori-ku**
**Yokohama-shi Kanagawa 227 (JP)**
Inventor: **Hirao, Hiroshi**
**Takizawa-so 3 11, Sugao Takatsu-ku**
**Kawasaki-shi Kanagawa 213 (JP)**

(74) Representative: **Allman, Peter John et al**
**MARKS & CLERK**
**Suite 301 Sunlight House Quay Street**
**Manchester M3 3JY (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

EP 0 060 078 B1

## Description

The present invention relates to a read-only memory (ROM) device, more particularly, to the output portion of a large capacity ROM device such as a mask ROM device or an EPROM (erasable programmable ROM) device.

In a mask ROM device, the binary data "0" or "1" of a memory cell at each intersection between word lines and bit lines corresponds to:

the presence or absence of an enhancement type transistor;

the high or low threshold voltage of a transistor;

the enhancement type or depletion type of a transistor; or

the presence or absence of a contact window (through-hole) which connects one of the bit lines to a transistor.

Similarly, in an EPROM device, the binary data "0" or "1" of a memory cell corresponds to the high or low threshold voltage of a transistor, which is determined by injecting carriers into a floating-gate thereof due to the tunnel effect of avalance breakdown. In any ROM device, since a memory cell only serves as a switch, a memory cell has no driving power for charging a corresponding bit line during the read mode. Therefore, one or more load elements are necessary for charging the bit lines during the read mode.

According to a first conventional ROM device, a plurality of switching transistors (gates) are provided between bit lines and data bus lines which are connected to a sense amplifier. When one of the switching transistors is selected by a group of column address decoders, the selected transistor is turned on so as to connect one of the bit lines to one of the data bus lines. As a result, one bit line is connected through the selected switching transistor to the sense amplifier. In this case, a load element is provided in the sense amplifier, so as to charge the selected bit line and all the data bus lines, that is, to pull up the potentials of these lines. Therefore, during the read mode, when the potential of a word line is caused to be high so as to select one memory cell, the memory data thereof is read out by decreasing the high potential of the selected bit line in the on-state memory cell or by retaining the potential of the selected bit line in the off-state memory cell.

In such a ROM device, when of a small capacity such as 16 kbits and 65 kbits, the load capacity of the data bus lines and the like driven by one load element is not so large as to cause any problem.

However, in a large capacity ROM device such as a 256 kbit device, the number of bit lines, the number of switching transistors, and the number of the data bus lines increase. As a result, in order to increase the pulling-up speed of the potentials of the selected bit line and the data bus lines, the driving power or conductance $g_m$ of the load element must increase. On the other hand, since the area of a memory cell becomes small, the conductance $g_m$ of an on-state memory cell also becomes small. As a result, the dimensions of the switching transistors must be large and, in addition, the conductance $g_m$ of the load element must decrease, since the ratio of the conductance $g_m$ of the on-state memory cell to that of the load element must be definite for ensuring the reliable read operation. After all, it is difficult to increase the driving power or conductance $g_m$ of the load element and, accordingly, it is difficult to perform rapid pulling-up of the potentials of the bit lines and the data bus lines and perform high speed read operation.

According to a second conventional ROM device, bit lines are divided into a plurality of groups. One bit line within each group is selected by first column address decoders and, in addition, one group is selected by second column address decoders. As a result, one selected bit line is connected to one of data bus line. Therefore, as compared with the first conventional device, the load capacity driven by the load element becomes small and, accordingly, the driving power of the load element in the sense amplifier may be small. However, even in this case, since only one load element is provided, it is difficult to perform rapid pull-up of the potential of the bit lines and the data bus lines and, accordingly, to perform high speed read operation in a large capacity ROM device such as a 256 kbit device.

It is known from US Patent Specification No. US—A—4103349 to obtain a high speed read operation by deriving the signal stored in a memory cell from a tier of decoders, the appropriate decoder being connected directly to an output driven by a gate controlled switch. The gate signal to render each switch conductive is generated by an AND-OR circuit in response to a unique column address code. Thus high speed operation is obtained by reducing the number of decoder tiers through which an evaluation signal must flow.

It is a principal object of the present invention to provide ROM device with high speed read operation even when the device is of a large capacity.

It is another object of the present invention to provide a ROM device having a simple structure.

According to the present invention, there is provided a read-only memory device comprising:

first and second power supply lines;

a plurality of word lines;

a plurality of groups of bit lines;

a plurality of read-only memory cells located at intersections between said word lines and said bit lines;

a plurality of data bus lines, the number of which is the same as that of said groups of bit lines;

a plurality of groups of switching gates, each group of switching gates being connected between one of said groups of bit lines and one of said data bus lines;

a plurality of first column decoders, connected to said switching gates, for selecting one switching gate within each group of switching gates in accordance with a first column address information, so as to turn on the selected switching gate;

a plurality of second column decoders, each connected to said first and second power supply lines and to one of said data bus lines, for selecting one of said data bus lines in accordance with a second column address information, so as to charge the selected data bus line;

a sense amplifier connected to said data bus lines; and

an output buffer connected to said sense amplifier, characterised in that each of the second column decoders includes a load element for pulling up the potential of the associated data bus lines, and that the data bus lines are separately connected to the sense amplifier.

The present invention will be more clearly understood from the description as set forth below contrasting the present invention with the conventional devices and with reference to the accompanying drawings, wherein:

Fig. 1 is a block circuit diagram illustrating a first conventional ROM device;

Fig. 2 is a partial circuit diagram of the device of Fig. 1;

Fig. 3 is a circuit diagram illustrating a second conventional ROM device;

Fig. 4 is a circuit diagram illustrating a third conventional ROM device similar to the second conventional device of Fig. 3;

Fig. 5 is a circuit diagram illustrating one embodiment of the ROM device according to the present invention; and

Fig. 6 is a circuit diagram illustrating another embodiment of the ROM device according to the present invention.

Fig. 1 illustrates a first conventional 256 kbit ($=2^{18}$) MOS (broadly, metal-insulated semiconductor (MIS)) ROM device. The device comprises row address buffers 1-0, 1-1, ..., 1-8 for converting row address signals $A_0, A_1, ..., A_8$ of a transistor-transistor logic (TTL) level into address signals $A_0, A_1, ..., A_8$ of a MOS level and their inverted signals $\overline{A}_0, \overline{A}_1, ..., \overline{A}_8$. In addition, the device comprises column address buffers 1-9, 1-10, ..., 1-14 for converting column address signals $A_9, A_{10}, ..., A_{14}$ of a TTL level into address signals $A_9, A_{10}, ..., A_{14}$ of a MOS level and their inverted signals $\overline{A}_9, \overline{A}_{10}, ..., \overline{A}_{14}$. Further, the device comprises row address decoders 2 for decoding the signals $A_0, \overline{A}_0, A_1, \overline{A}_1, ..., A_8, \overline{A}_8$ (MOS level) so as to select one of word lines $WL_0, WL_1, ... WL_{511}$, that is, one row from a memory cell array 3. In addition, the device comprises column address decoders 4 for decoding the address signals $A_9, \overline{A}_9, ..., A_{14}, \overline{A}_{14}$ (MOS level) so as to select one of column selection lines $C_0, C_1, ..., C_{63}$, that is, eight columns from the memory cell array 3. Therefore, eight of bit lines $BL_0, BL_1, ..., BL_{511}$ are selected and connected through a switching gate circuit 5 to sense amplifiers 6 which are also connected to output buffers 7. Thus, eight bit parallel data is obtained at output terminals $O_0, O_1, ..., O_7$.

Fig. 2 is a partial circuit diagram of the device of Fig. 1. In Fig. 2, only the circuit configuration regarding the output terminal $O_0$ is illustrated. The other circuit configurations regarding the output terminals $O_1$ through $O_7$ are omitted in order to simplify the description.

In the memory cell array 3, the binary data "0" or "1" of a memory cell $C_{00}$ ($C_{01}, ..., C_{511,63}$) at each intersection between the word lines $WL_0, WL_1, ..., WL_{511}$ and the bit lines $BL_0, BL_1, ..., BL_{63}$ corresponds to the presence or absence of a contact throughhole which connects one of the bit lines $BL_0, BL_1, ..., BL_{63}$ to a drain of a MOS transistor.

The switching gate circuit 5-0 comprises switching gates $G_0, G_1, ..., G_{63}$ which are selected by the column address decoders 4. When the switching gates $G_0, G_1, ..., G_{63}$, which are in this case MOS transistors, are turned on, the bit lines $BL_0, BL_1, ..., BL_{63}$ are electrically connected to data bus lines $DB_0, DB_1, ..., DB_{63}$, respectively.

The sense amplifier 6-0 comprises a depletion type source-gate connected MOS transistor $Q_L$ which serves as a load element, and three inverters $I_1$, $I_2$ and $I_3$. In this case, the load transistor $Q_L$ is used for charging all the data bus lines $DB_0, DB_1, ..., DB_{63}$, the switching gates $G_0, G_1, ..., G_{63}$ and one selected bit line, in other words, for pulling up the potentials thereof. For example, when only the switching gate $G_0$ is turned on and the potential of word line $WL_0$ is caused to be high so as to select the memory cell $C_{00}$, the potential of the bit line $BL_0$ is reduced since the conductance $g_m$ of the cell $C_{00}$ is set to be larger than that of the load transistor $Q_L$. Of course, in this case, the area of the switching gate $G_0$ is large enough. Therefore, the potential of the bit line $BL_0$ and the potentials of the data bus lines $DB_0, DB_1, ..., DB_{63}$ are pulled down. At this time, such low potential is sensed by the sense amplifier 6-0, and transmitted to an output buffer 7-0. Contrary to this, when only the switching gate $G_1$ is turned on and the potential of the word line $WL_0$ is caused to be high so as to select the memory cell $C_{01}$, the high potential of the bit line $BL_1$ remains at a high level, since the memory cell $C_{01}$ has no contact throughhole. Therefore, the potential of the bit line $BL_1$ and the potentials of the data bus lines $DB_0, DB_1, ..., DB_{63}$ remain at a high level. Such high potential is sensed by the sense amplifier 6-0 and transmitted to the output buffer 7-0. Although, in order to increase the pulling-up speed of the potentials of the bit lines and the data bus lines, the driving power or conductance $g_m$ of the load transistor $Q_L$ must be large, it is difficult to increase the driving power or conductance $g_m$ of the load transistor $Q_L$, because the conductances $g_m$ of the on-state memory cells are also small. Thus, in the device of Figs. 1 and 2, it is difficult to perform rapid pulling-up of the potentials of the bit lines $BL_0, BL_1, ..., BL_{63}$ and the data bus lines $DB_0, DB_1, ..., DB_{63}$. Further, since the column address decoders 4 are complex due to the large number thereof (which is, in Fig. 2, 64), the device

of Fig. 2 is large in scale.

Fig. 3 is a circuit diagram illustrating a second conventional ROM device. In Fig. 3, the bit lines $BL_0$, $BL_1$ ..., $BL_{63}$ are divided into a plurality of groups, for example, four groups. That is, the first group includes the bit lines $BL_0$, $BL_1$, ..., $BL_{15}$; the second group includes the bit lines $BL_{16}$, $BL_{17}$, ..., $BL_{31}$; the third group includes the bit lines $BL_{32}$, $BL_{33}$ ..., $BL_{47}$; and the fourth group includes the bit lines $BL_{48}$, $BL_{49}$ ..., $BL_{63}$. First column address decoders 4-1 decode the address signals $A_9$, $\overline{A}_9$, ..., $A_{12}$, $\overline{A}_{12}$ so as to select or turn on one switching gate at a common position of each of switching gate circuits 5'-0, 5'-1, 5'-2, and 5'-3 through column selection lines $C_0'$, $C_1'$, ..., $C_{15}'$. For example, when the potential of the line $C_0'$ is caused to be high, the switching gates $G_0'$, $G_{16}'$, $G_{32}'$, and $G_{48}'$ are turned on. In addition, second column decoders 4-2 decode the address signals $A_{13}$, $\overline{A}_{13}$, $A_{14}$ and $\overline{A}_{14}$ so as to select or turn on one of switching gates $G_{64}'$, $G_{65}'$, $G_{66}'$, and $G_{67}'$ through column selection lines $C_{16}'$, $C_{17}'$, $C_{18}'$, and $C_{19}'$. Therefore, since the number of column selection lines of the column address decoders 4-1 and 4-2 (which is, in Fig. 3, 20) is smaller as compared with the device of Figs. 1 and 2, the device of Fig. 3 is small.

The load transistor $Q_L$ of the sense amplifier 6-0 is used for charging the data bus lines $DB_0$, $DB_1$, $DB_2$ and $DB_3$ and the switching gates $G_{64}'$, $G_{65}'$, $G_{66}'$ and $G_{67}'$. In addition, if the switching gate $G_{64}'$ is turned on, the load transistor $Q_L$ charges the data bus lines $DB_0'$ through $DB_{15}'$ and the switching gates $G_0'$ through $G_{15}'$ and one of the bit lines $BL_0$ through $BL_{15}$. Therefore, the load capacity driven by the load transistor $Q_L$ is reduced as compared with the device of Fig. 2, and the pulling-up operation, that is, the read operation speed is improved.

Fig. 4 is a circuit diagram illustrating a third conventional ROM device similar to the second conventional device of Fig. 3. In Fig. 4, switching gates $G_{68}'$ through $G_{75}'$ which directly receive the address signals $A_{13}$, $\overline{A}_{13}$, $A_{14}$ and $\overline{A}_{14}$ are provided instead of the switching gates $G_{64}'$ through $G_{67}'$ of Fig. 3. Therefore, the switching gates $G_{68}'$ through $G_{75}'$ serve also as the decoders 4-2 of Fig. 3.

However, in any of the devices of Figs. 3 and 4, since the pulling-up operation is performed by one load transistor $Q_L$ provided in the sense amplifier 6-0, it is difficult to perform rapid pulling-up operation in a large capacity device such as a 256 kbit device. In addition, since switching gates are provided between the switching gate circuits 5'-0 through 5'-3 and the sense amplifier 6-0, the device is of a relatively complex structure.

Fig. 5 is a circuit diagram illustrating one embodiment of the ROM device according to the present invention. In Fig. 5, the switching gate circuits 5'-0, 5'-1, 5'-2, and 5'-3 are connected directly to the sense amplifier 6-0 by the data bus lines $DB_0$, $DB_1$, $DB_2$ and $DB_3$, respectively. That is, such switching gates $G_{64}'$ through $G_{75}'$ of Figs. 3 and 4 are not provided, which causes the device to be simple.

According to the present invention, second column decoders 8-0, 8-1, 8-3, and 8-4 each having load functions are provided. For example, the decoder 8-0 comprises: a depletion type source-gate connected transistor $Q_{L0}$ which serves as a load element; an AND circuit formed by two transistors $Q_{801}$ and $Q_{802}$ connected in series; and a NOR circuit formed by two transistors $Q_{803}$ and $Q_{804}$ connected in parallel. The transistors $Q_{801}$ and $Q_{802}$ have gates for receiving the address signals $\overline{A}_{13}$ and $\overline{A}_{14}$, respectively, while the transistors $Q_{803}$ and $Q_{804}$ have gates for receiving the address signals $A_{13}$ and $A_{14}$, respectively. The other decoders 8-1, 8-2, and 8-3 are of the same structure as the decoder 8-0.

For example, when the potentials of the address signals $A_{13}$ and $A_{14}$ are both low and, accordingly, the potentials of the address signals $\overline{A}_{13}$ and $\overline{A}_{14}$ are both high, the transistors $Q_{801}$ and $Q_{802}$ are turned on and the transistors $Q_{803}$ and $Q_{804}$ are turned off. As a result, the load transistor $Q_{L0}$ charges the data bus line $DB_0$ and the switching gates $G_0'$ through $G_{15}'$ of the switching gates circuit 5'-0. As a result, the potential of one of the bit lines $BL_0$ through $BL_{15}$ which is selected by the decoders 4-1 is pulled up to a high level. Thus, the decoder 8-0 is in the charging (pulling-up) mode. Note that, in this case, the other decoders 8-1, 8-2, and 8-3 are not in the charging mode, since, in these decoders, one or two of the transistors of the AND circuit are turned off and one or two of the transistors of the NOR circuit are turned on. In addition, when a selected cell (not shown) is conductive, such high potential of the selected bit line is decreased to be low and, accordingly, the potential of the data bus line $DB_0$ is decreased to be low. Contrary to this, when the selected cell is nonconductive, such high potential of the selected bit line remains high and, accordingly, the potential of the data bus line $DB_0$ remains high.

The sense amplifier 6-0 comprises a depletion type source-gate connected transistor, which serves as a load element, and a NOR circuit formed by transistors $Q_{60}$, $Q_{61}$, $Q_{62}$, and $Q_{63}$. For example, when the potential of the data bus line $DB_0$ is high and the potentials of the others are low, the output potential of the sense amplifier 6-0 is low. Contrary to this, when the potentials of all the data bus lines $DB_0$, $DB_1$, $DB_2$, and $DB_3$ are low, the output potential of the sense amplifier 6-0 is high.

In this embodiment of the present invention, one load transistor $Q_{L0}$ ($Q_{L1}$, $Q_{L2}$, $Q_{L3}$) is provided in each of the decoders 8-0, 8-1, 8-2, and 8-3 for driving a small number of data bus lines and bit lines. That is, since the load capacity driven by each load transistor $Q_{L0}$, $Q_{L1}$, $Q_{L2}$, or $Q_{L3}$ is small, it is possible to perform rapid pulling-up operation and, accordingly, perform rapid read operation.

It should be noted that, since the sense amplifier 6-0 uses a NOR circuit, the load capacity driven by the load transistor $Q_L$ is small, which is also advantageous in high speed read operation.

The circuit of Fig. 5 is based on n-channel transistor circuits, however, can also apply to p-channel transistor circuits.

Fig. 6 is a circuit diagram illustrating another embodiment of the ROM device according to the present invention. The device of Fig. 6 is manufactured by using Complementary MOS (CMOS) technology. That is, in the decoders 8-0, 8-1, 8-2, and 8-3, the transistors $Q_{801}'$, $Q_{802}'$, $Q_{811}'$, $Q_{812}'$, $Q_{821}'$, $Q_{832}'$, $Q_{831}'$, and $Q_{832}'$ are of a p-channel type, while the transistors $Q_{803}$, $Q_{804}$, $Q_{813}$, $Q_{814}$, $Q_{823}$, $Q_{824}$, $Q_{833}$, and $Q_{834}$ are of an n-channel type. In this case, the p-channel transistors are connected in series to each other so as to form AND circuits, while the n-channel transistors are connected in parallel to each other so as to form NOR circuits.

For example, when the potentials of the address signals $A_{13}$ and $A_{14}$ are both low, the p-channel type transistors $Q_{801}'$ and $Q_{802}'$ are turned on and the n-channel type transistors $Q_{803}$ and $Q_{804}$ are turned off. In this case, the on-state p-channel type transistors $Q_{801}'$ and $Q_{802}'$ is a load element. Therefore, the pulling-up (charging) operation by such a load element is performed. Of course, in this case, the other decoders 8-1, 8-2 and 8-3 are not in the pulling-up mode. As a result, the potential of a selected bit line is pulled up and this potential becomes low or high in accordance with the on-state or off-state of a selected cell. Note that, if at least one of the potentials of the address signals $A_{13}$ and $A_{14}$ is high, the p-channel type transistors $Q_{801}$ and $Q_{802}$ do not as a whole serve as a load element, which is advantageous in power dissipation.

In the sense amplifier 6-0, p-channel type transistors $Q_{L4}$, $A_{L5}$, $Q_{L6}$ and $Q_{L7}$ are connected in series to each other. When the potentials of the data bus lines $DB_0$, $DB_1$, $DB_2$, and $DB_3$ are all low, the p-channel type transistors $Q_{L4}$, $Q_{L5}$, $Q_{L6}$, and $Q_{L7}$ are all turned on. In this case, these transistors as a whole serve as a load element in the same way as the load transistors $Q_L$ of Fig. 5. However, if at least one of the data bus lines $DB_0$, $DB_1$, $DB_2$, and $DB_3$ is high, these transistors do not as a whole serve as a load element, which is advantageous in power dissipation.

In the above-mentioned embodiments of the present invention, bit lines are divided into four groups. However, the bit lines can be divided into any number of groups.

As explained hereinbefore, the ROM device according to the present invention has an advantage, as compared with the conventional device of Fig. 3 or 4, in that rapid pulling-up operation, that is, high speed read operation, can be performed since the load capacity driven by one load element is small. In addition, the device according to the present invention is of a simple structure since the switching gate circuits 5'-0, 5'-1, 5'-2, and 5'-3 are connected directly to the sense amplifier 6-0.

**Claims**

1. A read-only memory device comprising:

first and second power supply lines ($V_{cc}$, $V_{ss}$);

a plurality of word lines ($WL_0$—$WL_{511}$);

a plurality of groups of bit lines ($BL_0$—$BL_{15}$, $BL_{16}$—$BL_{31}$, $BL_{32}$—$BL_{47}$, $BL_{48}$—$BL_{63}$);

a plurality of read-only memory cells located at intersections between said word lines and said bit lines;

a plurality of data bus lines ($DB_0$—$DB_3$), the number of which is the same as that of said groups of bit lines;

a plurality of groups of switching gates (5'-0 to 5'-3), each group of switching gates being connected between one of said groups of bit lines and one of said data bus lines;

a plurality of first column decoders (4-1), connected to said switching gates, for selecting one switching gate within each group of switching gates in accordance with a first column address information, so as to turn on the selected switching gate;

a plurality of second column decoders (8-0 to 8-3), each connected to said first and second power supply lines and to one of said data bus lines, for selecting one of said data bus lines in accordance with a second column address information, so as to charge the selected data bus line;

a sense amplifier (6-0) connected to said data bus lines; and

an output buffer (7-0) connected to said sense amplifier, characterised in that each of the second column decoders (8-0 to 8-3) includes a load element ($Q_{L0}$—$Q_{L3}$, $Q_{801}'$, $Q_{802}'$) for pulling up the potential of the associated data bus lines ($DB_0$—$DB_3$),and that the data bus lines ($DB_0$—$DB_3$) are separately connected to the sense amplifier (6-0).

2. A device as set forth in claim 1, wherein each of said second column decoders comprises:

an AND circuit ($Q_{801}$, $Q_{802}$—$Q_{831}$, $Q_{832}$), operatively connected to said first power supply line ($V_{cc}$) and to one of said data bus lines, for receiving one combination of said second column address information; and

a NOR circuit ($Q_{803}$, $Q_{804}$—$Q_{833}$, $Q_{834}$), connected to said AND circuit and to said second power supply line ($V_{ss}$), for receiving the inverted information of said one combination of said second column information.

3. A device as set forth in claim 2, wherein the load element is connected between said first power supply line and said AND circuit, said load element comprising a depletion type source-gate connected metal-insulated semiconductor (MIS) transistor.

4. A device as set forth in claim 3, wherein said AND circuit comprises a plurality of MIS transistors ($Q_{801}$, $Q_{802}$—$Q_{831}$, $Q_{832}$) connected in series having gates for receiving the combination of said second column address information.

5. A device as set forth in claim 3, wherein said NOR circuit comprises a plurality of MIS transistors ($Q_{803}$, $Q_{804}$—$Q_{833}$, $Q_{834}$) connected in parallel having gates for receiving the inverted information of said one combination of said second column address information.

6. A device as set forth in claim 2, wherein the load element ($Q_{801}'$, $Q_{802}'$—$Q_{831}'$, $Q_{832}'$) is connected to said first power supply line ($V_{cc}$), and the NOR circuit ($Q_{803}$, $Q_{804}$—$Q_{833}$, $Q_{834}$) is connected to said load element and to said second power supply line ($V_{ss}$), the NOR circuit having gates for receiving the potentials of said data bus lines.

7. A device as set forth in claim 6, wherein said NOR circuit comprises a plurality of MIS transistors ($Q_{803}$, $Q_{804}$—$Q_{833}$, $Q_{834}$) connected in parallel.

8. A device as set forth in claim 1, wherein each of said second column decoders comprises:

a plurality of MIS transistors ($Q_{801}'$, $Q_{802}'$—$Q_{831}'$, $Q_{832}'$) of a first conductivity type connected in series between said first power supply line ($V_{cc}$) and one of said data bus lines and having gates for receiving one combination of said second column address information; and

a plurality of MIS transistors ($Q_{803}$, $Q_{804}$—$Q_{833}$, $Q_{834}$) of a second conductivity type connected in parallel between said second power supply line ($V_{ss}$) and one of said data bus lines and having gates for receiving said one combination of said second column address information.

9. A device as set forth in claim 8, wherein said sense amplifier comprises:

a plurality of MIS transistors ($Q_{L4}$—$Q_{L7}$) of said first conductivity type connected in series between said first power supply line ($V_{cc}$) and said output buffer (7-0) and having gates for receiving the potentials of said data bus lines; and

a plurality of MIS transistors ($Q_{60}$—$Q_{63}$) of said second conductivity type connected in parallel between said second power supply line ($V_{ss}$) and said output buffer (7-0) and having gates for receiving the potentials of said data bus lines.

**Patentansprüche**

1. Festwertspeichervorrichtung mit:

ersten und zweiten Energieversorgungsleitungen ($V_{cc}$, $V_{ss}$);

einer Vielzahl von Wortleitungen ($WL_0$—$WL_{511}$);

einer Vielzahl von Gruppen von Bitleitungen ($BL_0$—$BL_{15}$, $BL_{16}$—$BL_{31}$, $BL_{32}$—$BL_{47}$, $BL_{48}$—$BL_{63}$);

einer Vielzahl von Festwertspeicherzellen, die an Schnittpunkten zwischen den genannten Wortleitungen und den genannten Bitleitungen angeordnet sind;

einer Vielzahl von Datenbusleitungen ($DB_0$—$DB_3$), deren Anzahl dieselbe ist wie diejenige der genannten Gruppen von Bitleitungen;

einer Vielzahl von Gruppen von Schaltverknüpfungsgliedern (5'-0 bis 5'-3), von denen jede Gruppe von Verknüpfungsgliedern zwischen einer der genannten Gruppen von Bitleitungen und einer der genannten Datenbusleitungen verbunden ist;

einer Vielzahl von ersten Spaltendecodern (4-1), die mit den genannten Verknüpfungsgliedern verbunden sind, um ein Verknüpfungsglied innerhalb jeder Gruppe von Verknüpfungsgliedern in Übereinstimmung mit einer ersten Spaltenadresseninformation auszuwählen, um so das ausgewählte Verknüpfungsglied einzuschalten;

einer Vielzahl von zweiten Spaltendecodern (8-0 bis 8-3), die jeweils mit den genannten ersten und zweiten Energieversorgungsleitungen und mit einer der genannten Datenbusleitungen verbunden sind, um eine der genannten Datenbusleitungen in Übereinstimmung mit einer zweiten Spaltenadresseninformation auszuwählen, um so die ausgewählte Datenbusleitung zu laden;

einem Leseverstärker (6-0), der mit den genannten Datenbusleitungen verbunden ist; und einem Ausgangspuffer (7-0), der mit dem genannten Leseverstärker verbunden ist, dadurch gekennzeichnet, daß jeder der zweiten Spaltendecoder (8-0 bis 8-3) ein Lastelement ($Q_{L0}$—$Q_{L3}$, $Q_{801}'$, $Q_{802}'$) umfaßt, um das Potential der zugeordneten Datenbusleitungen ($DB_0$—$DB_3$) hochzuziehen, und das die Datenbusleitungen ($DB_0$—$DB_3$) separat mit dem Leseverstärker (6-0) verbunden sind.

2. Vorrichtung nach Anspruch 1, bei der jeder der genannten Spaltendecoder umfaßt:

eine UND-Schaltung ($Q_{801}$, $Q_{802}$—$Q_{831}$,$Q_{832}$), die wirkungsmäßig mit der genannten ersten Energieversorgungsleitung ($V_{cc}$) und mit einer der genannten Datenbusleitungen verbunden sind, um eine Kombination der genannten zweiten Spaltenadresseninformation zu empfangen; und

einer NOR-Schaltung ($Q_{803}$, $Q_{804}$—$Q_{833}$, $Q_{834}$), die mit der genannten UND-Schaltung und der genannten zweiten Energieversorgungsleitung ($V_{ss}$) verbunden ist, um die invertierte Information der genannten einen Kombination der genannten zweiten Spalteninformation zu empfangen.

3. Vorrichtung nach Anspruch 2, bei der das Lastelement zwischen der genannten ersten Energieversorgungsleitung und der genannten UND-Schaltung verbunden ist, das genannte Lastelement einen Source-Gate-verbundenen Metall-Isolierten-Halbleiter-(MIS)-Transistor vom Verarmungstyp umfaßt.

4. Vorrichtung nach Anspruch 3, bei der die genannte UND-Schaltung eine Vielzahl von MIS-Transistoren ($Q_{801}$, $Q_{802}$—$Q_{831}$, $Q_{832}$) umfaßt, die in Reihe verbunden sind und Gates zum Empfang der Kombination der genannten zweiten Spaltenadresseninformation haben.

5. Vorrichtung nach Anspruch 3, bei der die genannte NOR-Schaltung eine Vielzahl von MIS-Transistoren ($Q_{803}$, $Q_{804}$—$Q_{833}$, $Q_{834}$) umfaßt, die parallel verbunden sind und Gates zum Empfang der invertierten Information der genannten einen Kombination der genannten zweiten Spaltenadresseninformation haben.

6. Vorrichtung nach Anspruch 2, bei der das Lastelement ($Q_{801}'$, $Q_{802}'$—$Q_{831}'$, $Q_{832}'$) mit der genannten ersten Energieversorgungsleitung ($V_{cc}$) verbunden ist, und die NOR-Schaltung ($Q_{803}$, $Q_{804}$—$Q_{833}$, $Q_{834}$) mit dem genannten Lastelement und der genannten zweiten Energieversorgungsleitung ($V_{ss}$) verbunden ist, und die NOR-Schaltung Gates zum Empfang der Potentiale der genannten Datenbusleitungen hat.

7. Vorrichtung nach Anspruch 6, bei der die genannte NOR-Schaltung eine Vielzahl von MIS-Transistoren ($Q_{803}$, $Q_{804}$—$Q_{833}$, $Q_{834}$) hat, die parallel verbunden sind.

8. Vorrichtung nach Anspruch 1, bei der jeder der genannten zweiten Spaltendecoder umfaßt:

eine Vielzahl von MIS-Transistoren ($Q_{801}'$, $Q_{802}'$—$Q_{831}'$, $Q_{832}'$) von einem ersten Leitfähigkeitstyp, die in Reihe zwischen der genannten ersten Energieversorgungsleitung ($V_{cc}$) und einer der genannten Datenbusleitungen verbunden sind und Gates zum Empfang einer Kombination der genannten zweiten Spaltenadresseninformation haben; und

eine Vielzahl von MIS-Transistoren ($Q_{803}$, $Q_{804}$—$Q_{833}$, $Q_{834}$) von einem zweiten Leitfähigkeitstyp, die parallel zwischen der genannten zweiten Energieversorgungsleitung ($V_{ss}$) und einer der genannten Datenbusleitungen angeschlossen sind und Gates zum Empfang der genannten einem Kombination der genannten zweiten Spaltenadresseninformation haben.

9. Vorrichtung nach Anspruch 8, bei der der genannte Leseverstärker umfaßt:

eine Vielzahl von MIS-Transistoren ($Q_{L4}$—$Q_{L7}$) von dem genannten ersten Leitfähigkeitstyp, die in Reihen zwischen der genannten ersten Energieversorgungsleitung ($V_{cc}$) und dem genannten Ausgabepuffer (7-0) verbunden sind und Gates für den Empfang der Potentiale der genannten Datenbusleitungen haben; und

eine Vielzahl von MIS-Transistoren ($Q_{60}$—$Q_{63}$) von dem genannten zweiten Leitfähigkeitstyp, die parallel zwischen der genannten zweiten Energieversorgungsleitung ($V_{ss}$) und dem genannten Ausgabepuffer (7-0) angeschlossen sind und Gates zum Empfang der Potentiale der genannten Datenbusleitungen haben.

**Revendications**

1. Dispositif de mémoire morte comprenant:

des première et deuxième lignes de tension d'alimentation ($V_{cc}$, $V_{ss}$);

un ensemble de fils de mot ($WL_0$—$WL_{511}$);

un ensemble de groupes de fils de bit ($BL_0$—$BL_{15}$, $BL_{16}$—$BL_{31}$, $BL_{32}$—$BL_{47}$, $BL_{48}$—$BL_{63}$);

un ensemble de cellules de mémoire morte placées aux intersections entre les fils de mot et les fils de bit;

un ensemble de fils de bus de données ($DB_0$—$DB_3$) dont le nombre est le même que celui des groupes de fils de bit;

un ensemble de groupes de portes de commutation (5'-0 à 5'-3), chaque groupe de portes de commutation étant connecté entre un des groupes de fils de bit et un des fils de bus de données;

un ensemble de premiers décodeurs de colonne (4-1), connectés aux portes de commutation, pour sélectionner une porte de commutation à l'intérieur de chaque groupe de portes de commutation conformément à des premières informations d'adresse de colonne, de manière à rendre conductrice la porte de commutation sélectionnée;

un ensemble de seconds décodeurs de colonne (8-0 à 8-3), connectés chacun aux première et deuxième lignes de tension d'alimentation et à un des fils de bus de données, pour sélectionner un des fils de bus de données conformément à des deuxièmes informations d'adresse de colonne, de manière à charger le fil de bus de données sélectionné;

un amplificateur de détection (6-0) connecté aux fils de bus de données; et

un tampon de sortie (7-0) connecté à l'amplificateur de détection,

caractérisé en ce que

chacun de seconds décodeurs de colonne (8-0 à 8-3) comprend un élément de charge ($Q_{L0}$—$Q_{L3}$; $Q_{801}'$—$Q_{802}'$) pour élever le potentiel des fils de bus de données associés ($DB_0$—$DB_3$), et en ce que les fils de bus de données ($DB_0$—$DB_3$) sont connectés séparément à l'amplificateur de détection (6-0).

2. Dispositif selon la revendication 1, dans lequel chacun des seconds décodeurs de colonne comprend:

un circuit ET ($Q_{801}$, $Q_{802}$—$Q_{831}$, $Q_{832}$), connecté activement à la première ligne de tension d'alimentation ($V_{cc}$) et à un des fils de bus de données, pour recevoir une combinaison des deuxièmes informations d'adresse de colonne; et

un circuit NI ($Q_{803}$, $Q_{804}$—$Q_{833}$, $Q_{834}$), connecté au circuit ET et à la deuxième ligne de tension d'alimentation ($V_{ss}$) pour recevoir les informations inversées de ladite combinaison des deuxièmes informations de colonne.

3. Dispositif selon la revendication 2, dans lequel l'élément de charge est connecté entre la première ligne de tension d'alimentation et le circuit ET, l'élément de charge comprenant un transistor à métal-isolant-semiconducteur (MIS) à source-grille connectées du type à appauvrissement.

4. Dispositif selon la revendication 3, dans lequel le circuit ET comprend un ensemble de transistors MIS ($Q_{801}$, $Q_{802}$—$Q_{831}$, $Q_{832}$) connectés en série, comportant des grilles pour recevoir la combinaison des deuxièmes informations d'adresse de colonne.

5. Dispositif selon la revendication 3, dans lequel le circuit NI comprend un ensemble de transistors MIS ($Q_{803}$, $Q_{804}$—$Q_{833}$, $Q_{834}$) connectés en parallèle, comportant des grilles pour recevoir les informations inversées de ladite combinaison des deuxièmes informations d'adresse de colonne.

6. Dispositif selon la revendication 2, dans lequel l'élément de charge ($Q_{801}'$, $Q_{802}'$—$Q_{831}'$, $Q_{832}'$) est connecté à la premièr ligne de tension d'alimentation ($V_{cc}$), et le circuit NI ($Q_{803}$, $Q_{804}$—$Q_{833}$, $Q_{834}$) est connecté à l'élément de charge et à la deuxième ligne de tension d'alimentation ($V_{ss}$), le circuit NI comportant des grilles pour recevoir les potentiels des fils de bus de données.

7. Dispositif selon la revendication 6, dans lequel le circuit NI comprend un ensemble de

transistors MIS ($Q_{803}$, $Q_{804}$—$Q_{833}$, $Q_{834}$) connectés en parallèle.

8. Dispositif selon la revendication 1, dans lequel chacun des seconds décodeurs de colonne comprend:

un ensemble de transistors MIS ($Q_{801}'$, $Q_{802}'$—$Q_{831}'$, $Q_{832}'$) d'un premier type de conductivité connectés en série entre la première ligne de tension d'alimentation ($V_{cc}$) et un des fils de bus de données et comportant des grilles pour recevoir une combinaison des deuxièmes informations d'adresse de colonne; et

un ensemble de transistors MIS ($Q_{803}$, $Q_{804}$—$Q_{833}$, $Q_{834}$) d'un second type de conductivité connectés en parallèle entre la deuxième ligne de tension d'alimentation ($V_{ss}$) et un des fils de bus de données et comportant des grilles pour recevoir ladite combinaison des deuxièmes informations d'adresse de colonne.

9. Dispositif selon la revendication 8, dans lequel l'amplificateur de détection comprend:

un ensemble de transistors MIS ($Q_{L4}$—$Q_{L7}$) du premier type de conductivité connectés en série entre la première ligne de tension d'alimentation ($V_{cc}$) et le tampon de sortie (7-0) et comportant des grilles pour recevoir les potentiels des fils de bus de données; et

un ensemble de transistors MIS ($Q_{60}$—$Q_{63}$) du second type de conductivité connectés en parallèle entre la deuxième ligne de tension d'alimentation ($V_{ss}$) et le tampon de sortie (7-0) et comportant des grilles pour recevoir les potentiels des fils de bus de données.

*Fig. 1* (Prior Art)

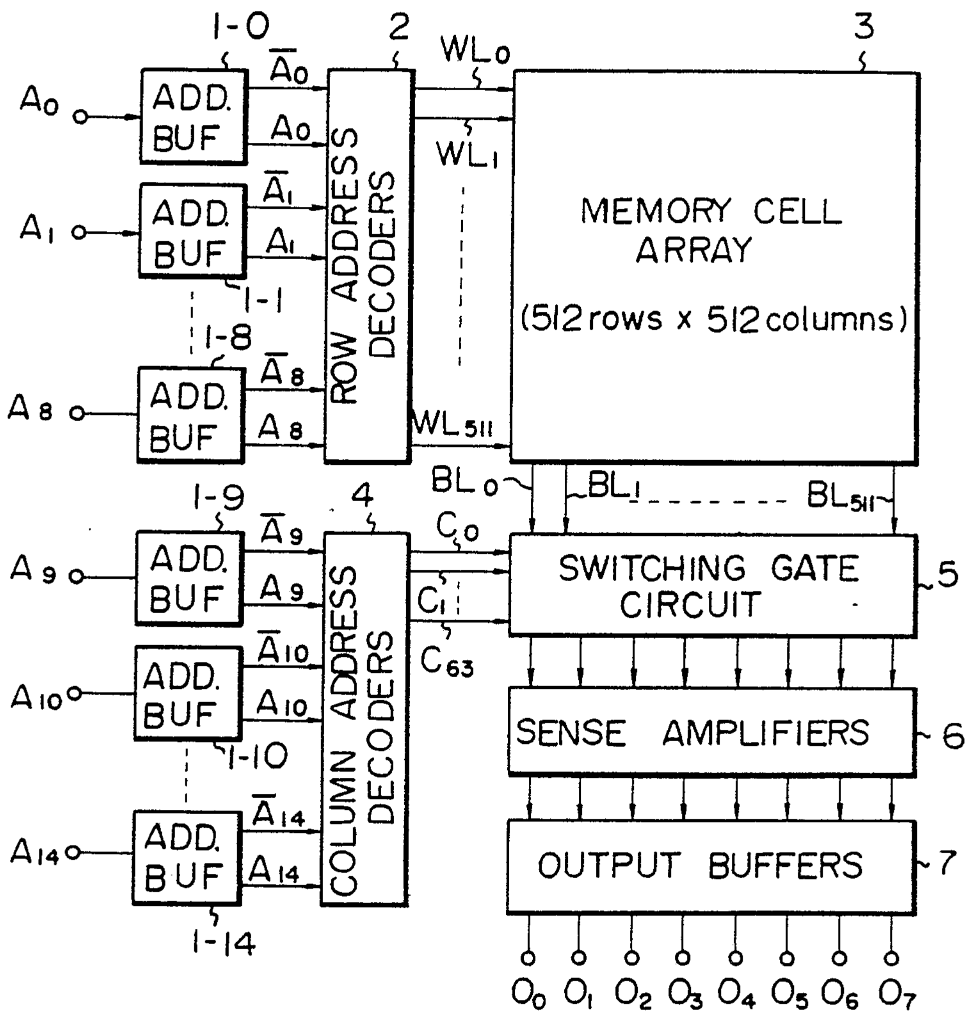

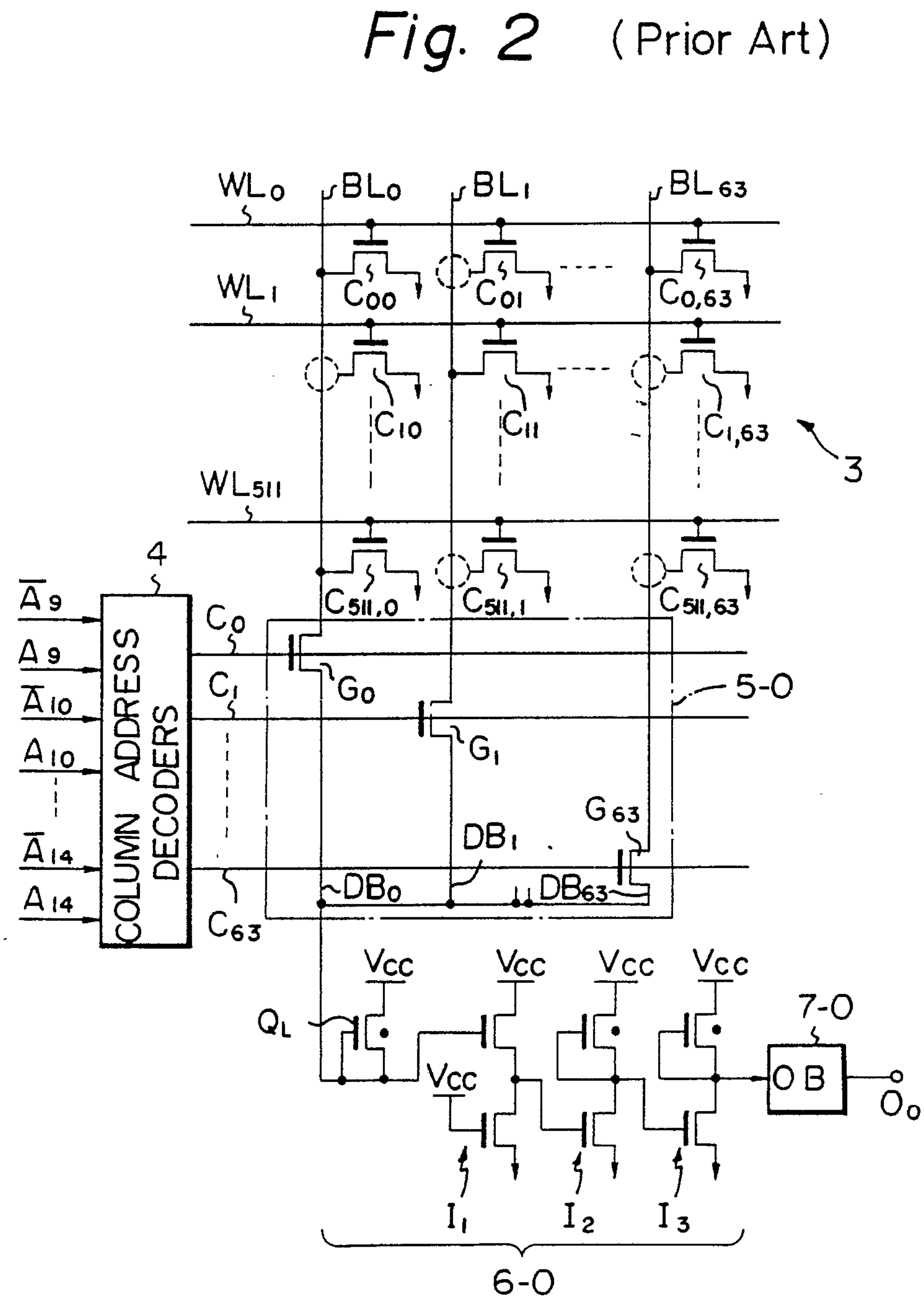
Fig. 2 (Prior Art)
WL0
BL0
BL1
BL63
C00
C01
C0,63
WL1
C10
C11
C1,63
3
WL511
C511,0
C511,1
C511,63
4
A9
A9
A10
A10
A14
A14
COLUMN ADDRESS DECODERS
C0
C1
C63
G0
G1
G63
5-0
DB1
DB0
DB63
Vcc
Vcc
Vcc
Vcc
Vcc
QL
7-0
OB
O0
I1
I2
I3
6-0

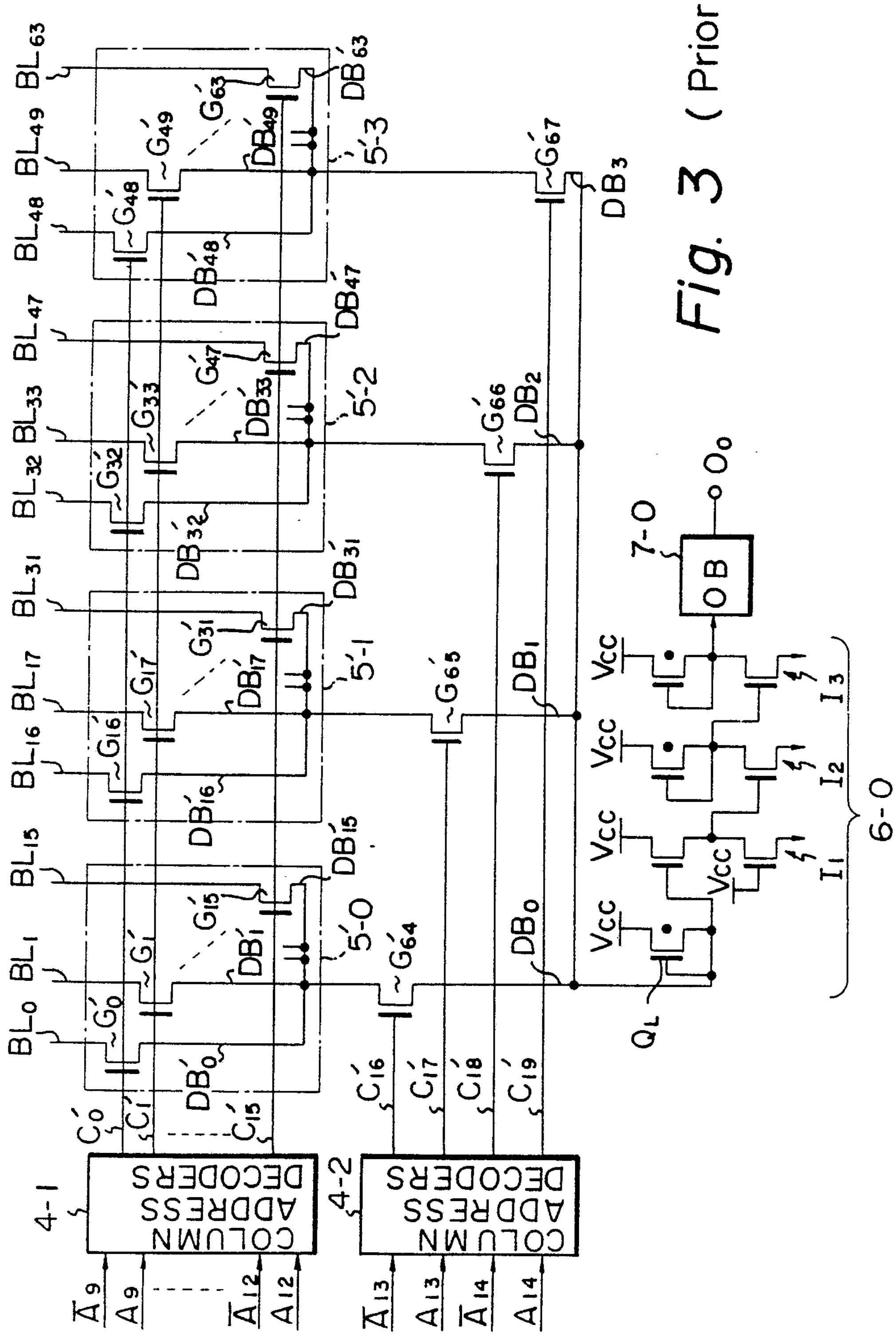


Fig. 3 (Prior Art)

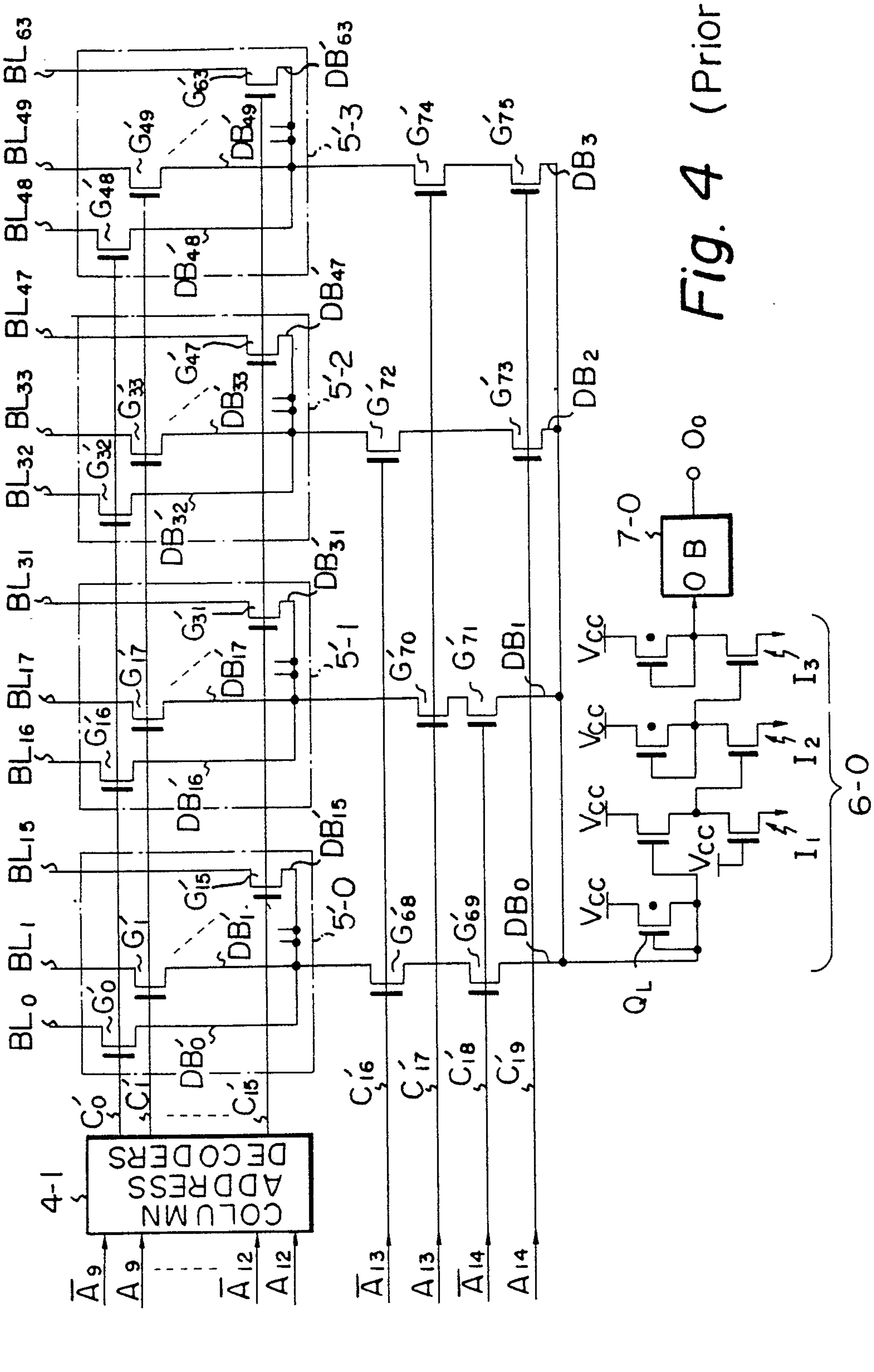


Fig. 4 (Prior Art)

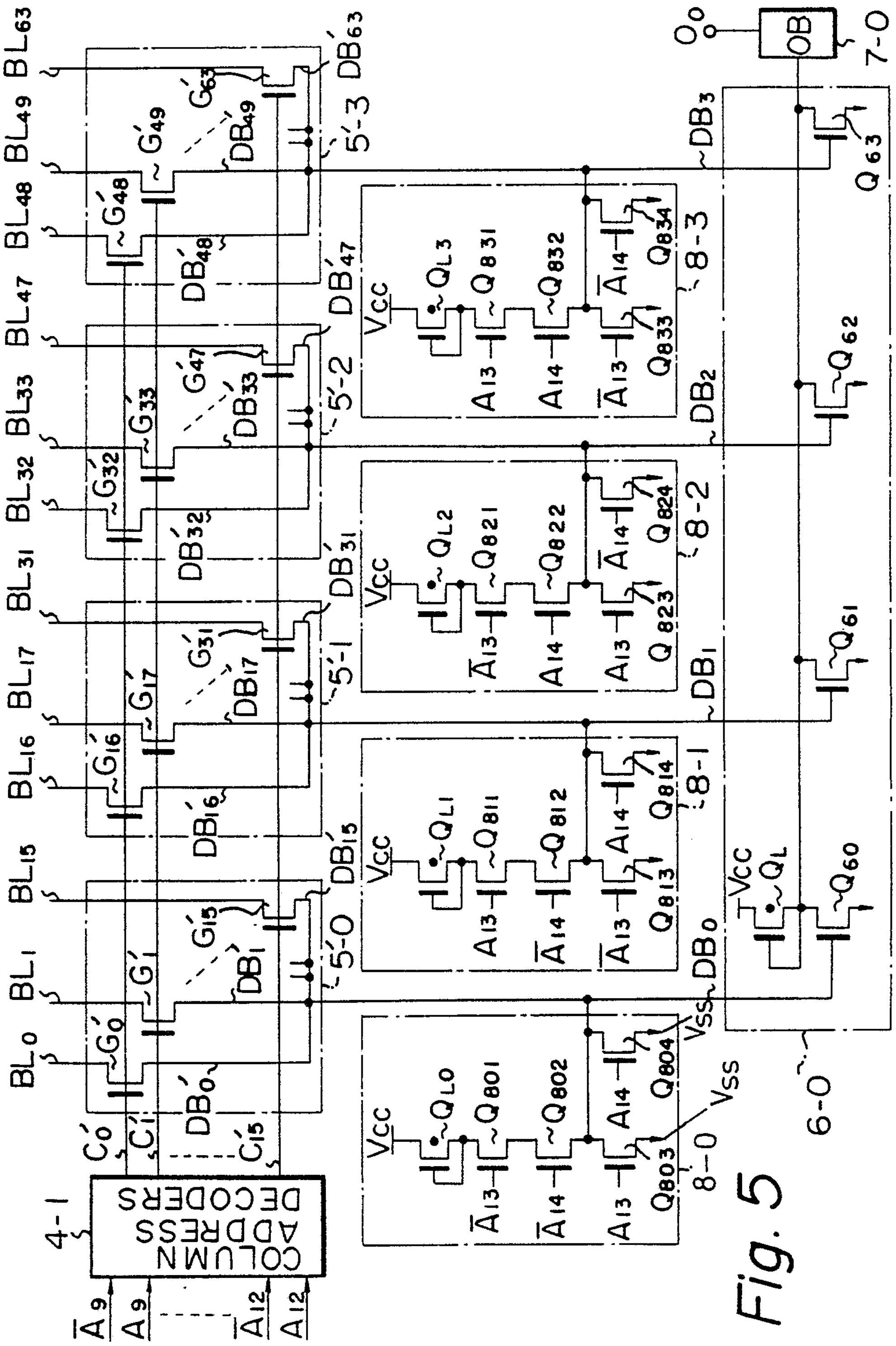
COLUMN ADDRESS DECODERS
4-1
$\bar{A}_9$
$A_9$
$\bar{A}_{12}$
$A_{12}$
$C_0'$
$C_1'$
$C_{15}'$
$BL_0$
$BL_1$
$BL_{15}$
$BL_{16}$
$BL_{17}$
$BL_{31}$
$BL_{32}$
$BL_{33}$
$BL_{47}$
$BL_{48}$
$BL_{49}$
$BL_{63}$
$G_0'$
$G_1'$
$G_{15}'$
$G_{16}'$
$G_{17}'$
$G_{31}'$
$G_{32}'$
$G_{33}'$
$G_{47}'$
$G_{48}'$
$G_{49}'$
$G_{63}'$
$DB_0'$
$DB_1'$
$DB_{15}'$
$DB_{16}'$
$DB_{17}'$
$DB_{31}'$
$DB_{32}'$
$DB_{33}'$
$DB_{47}'$
$DB_{48}'$
$DB_{49}'$
$DB_{63}'$
5'-0
5'-1
5'-2
5'-3
$DB_0$
$DB_1$
$DB_2$
$DB_3$
8-0
8-1
8-2
8-3
$V_{CC}$
$V_{SS}$
$Q_{L0}$
$Q_{L1}$
$Q_{L2}$
$Q_{L3}$
$Q_L$
$Q_{801}$
$Q_{802}$
$Q_{803}$
$Q_{804}$
$Q_{811}$
$Q_{812}$
$Q_{813}$
$Q_{814}$
$Q_{821}$
$Q_{822}$
$Q_{823}$
$Q_{824}$
$Q_{831}$
$Q_{832}$
$Q_{833}$
$Q_{834}$
$A_{13}$
$\bar{A}_{13}$
$A_{14}$
$\bar{A}_{14}$
$Q_{60}$
$Q_{61}$
$Q_{62}$
$Q_{63}$
6-0
OB
7-0
$O_0$

Fig. 5

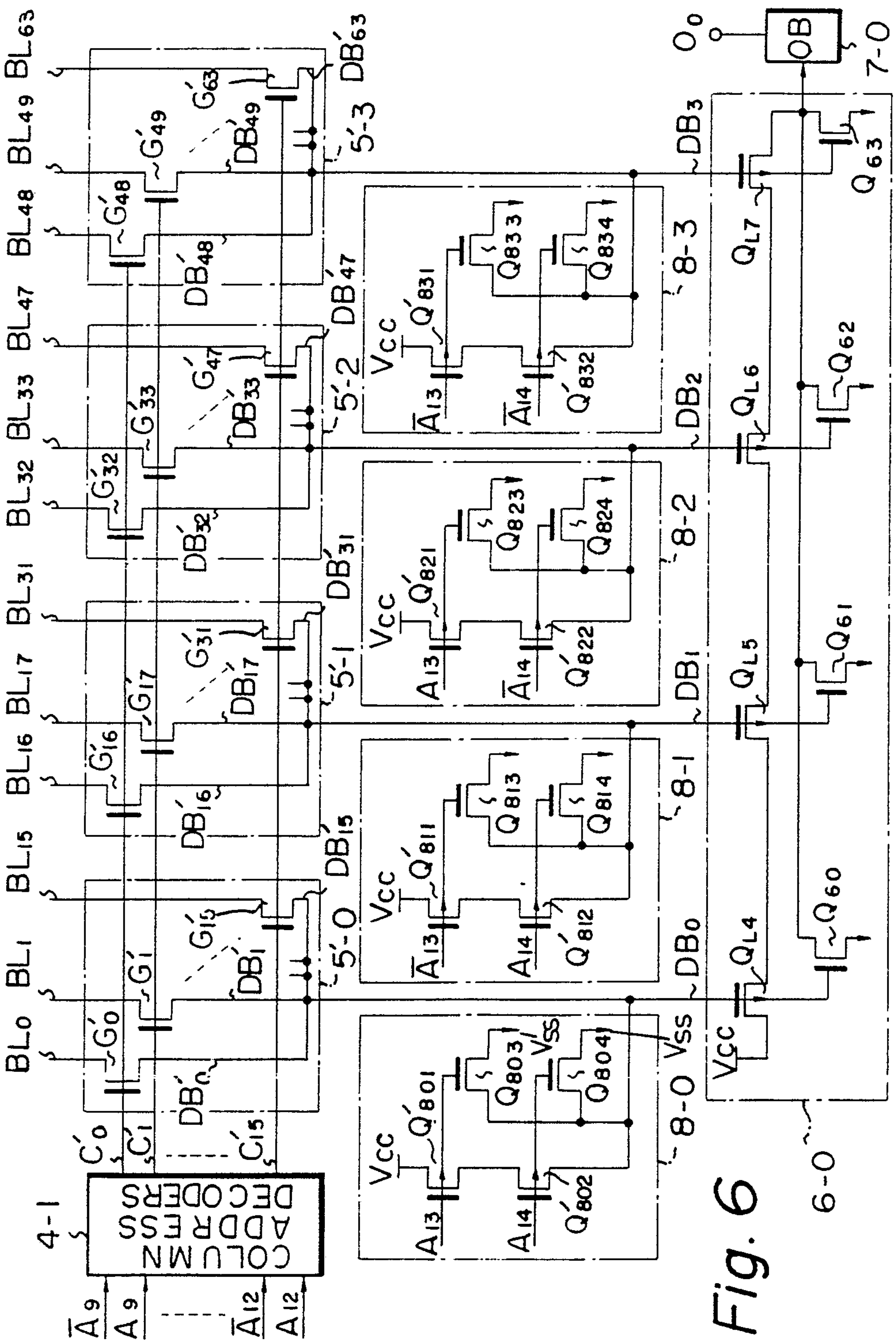

BL0
BL1
BL15
BL16
BL17
BL31
BL32
BL33
BL47
BL48
BL49
BL63
4-1
COLUMN ADDRESS DECODERS
Ā9
A9
Ā12
A12
C'0
C'1
C'15
G'0
G'1
G'15
G'16
G'17
G'31
G'32
G'33
G'47
G'48
G'49
G'63
DB'0
DB'1
DB'15
DB'16
DB'17
DB'31
DB'32
DB'33
DB'47
DB'48
DB'49
DB'63
5'-0
5'-1
5'-2
5'-3
Vcc
Q'801
Q'802
Q803
Q804
V'ss
Vss
A13
A14
8-0
Ā13
Q'811
Q'812
Q813
Q814
8-1
Q'821
Q'822
Q823
Q824
Ā14
8-2
Q'831
Q'832
Q833
Q834
8-3
DB0
DB1
DB2
DB3
QL4
QL5
QL6
QL7
Q60
Q61
Q62
Q63
6-0
OB
7-0
O0

Fig. 6